**Europäisches Patentamt**

**European Patent Office**

**Office européen des brevets**

(19)

(11) Numéro de publication: **0 086 140 B1**

(12) **FASCICULE DE BREVET EUROPEEN**

(45) Date de publication du fascicule du brevet:
**10.12.86**

(51) Int. Cl.⁴: **H 03 M 1/60,** H 03 K 7/06

(21) Numéro de dépôt: **83400192.7**

(22) Date de dépôt: **28.01.83**

(54) **Convertisseur tension fréquence à haute stabilité.**

(30) Priorité: **29.01.82 FR 8201401**

(43) Date de publication de la demande:
**17.08.83 Bulletin 83/33**

(45) Mention de la délivrance du brevet:
**10.12.86 Bulletin 86/50**

(84) Etats contractants désignés:
**CH DE GB IT LI SE**

(56) Documents cités:
**DE - A - 2 519 668**
**FR - A - 2 195 873**
**GB - A - 1 153 201**

(73) Titulaire: **ENERTEC SOCIETE ANONYME, 12, Place des Etats-Unis, F-92120 Montrouge (FR)**

(72) Inventeur: **Ley, Anthony-John, 9, avenue du Lieutenant Jean-Masset, F-92230 Sceaux (FR)**
Inventeur: **Bazin, Alain, 8, Allée Berlioz, F-94800 Villejuif (FR)**

(74) Mandataire: **Bentz, Jean-Paul, GIERS SCHLUMBERGER Service BREVETS 12, place des Etats-Unis, F-92124 Montrouge Cedex (FR)**

**Description**

La présente invention concerne des convertisseurs tension-fréquence à haute stabilité, c'est-à-dire des circuits qui fournissent un signal de sortie oscillant dont la fréquence est représentative de l'amplitude d'un signal d'entrée. Ces circuits sont par exemple couramment utilisés pour effectuer une conversion analogique-numérique.

Les convertisseurs tension-fréquence de type connu comprennent essentiellement d'une part un intégrateur destiné à intégrer le signal d'entrée et des impulsions de retour fournies à l'intégrateur à une fréquence et avec une polarité telles que le signal de sortie de l'intégrateur est astreint à conserver une valeur au plus égale à une valeur de seuil prédéterminée, et d'autre part un générateur d'impulsions de retour, fonctionnellement relié à la sortie de l'intégrateur, et commandé pour fournir à l'intégrateur une impulsion de retour chaque fois que le signal de sortie de cet intégrateur atteint ladite valeur de seuil.

Dans ces convertisseurs, dits «asynchrones», et dont le document DE-A-2 519 668 donne un exemple, le générateur d'impulsions de retour est généralement essentiellement constitué par un circuit monostable.

La tension d'entrée est appliquée à l'intégrateur, dont le signal de sortie est comparé à la valeur de seuil par un comparateur. Chaque fois que le seuil est dépassé, le comparateur envoie un signal à un circuit de commande qui déclenche alors le circuit monostable pour fournir à l'intégrateur une impulsion de retour, c'est-à-dire une impulsion de contre-réaction, opposée au signal d'entrée. La fréquence instantanée à laquelle les impulsions de retour doivent être fournies pour maintenir le signal de sortie de l'intégrateur en-dessous du seuil dépend de l'amplitude de la tension d'entrée, et fournit donc une indication numérique de cette amplitude.

Les convertisseurs de ce type ne comprennent aucune horloge indépendante commandant l'instant d'apparition de chacune des impulsions de retour, de sorte que l'obtention d'un haut degré de précision ne pose pas le problème de choisir entre une cadence d'horloge très élevée (nécessitant des circuits spécialisés et impliquant une conception délicate) et une faible vitesse de conversion (qui n'est pas toujours acceptable), ni le problème des bruits de quantification liés à l'utilisation d'une fréquence d'horloge fixe. En revanche, dans les convertisseurs asynchrones connus, et notamment dans le convertisseur décrit dans le document DE-A-2 519 668, la précision de la conversion dépend de la précision du circuit de base de temps qui prend généralement la forme d'un condensateur incorporé au circuit monostable et dont la valeur détermine la durée de l'impulsion de retour. En conséquence, la précision n'est généralement pas supérieure à 0,1%–1%. Bien que cela soit suffisant pour de nombreuses applications, dans certaines circonstances, comme par exemple pour la télémétrie des signaux de mesure dans des systèmes de transmission d'électricité et de contrôle de procesus, une précision supérieure et une vitesse de conversion élevée sont nécessaires.

Dans ce contexte, le but de la présente invention est de proposer un convertisseur tension-fréquence de type asynchrone dont la précision soit sensiblement supérieure à celle des convertisseurs connus du même type.

A cette fin, le convertisseur de l'invention est essentiellement caractérisé en ce qu'il comprend, en plus de l'intégrateur et du générateur d'impulsions de retour, d'une part un générateur d'impulsions de référence délivrant, à une fréquence dépendant de celle des impulsions de retour, des impulsions de référence calibrées, et d'autre part un second intégrateur intégrant, avec des polarités opposées, les impulsions de retour et de référence, le signal de sortie de ce second intégrateur étant appliqué à une entrée de contrôle de durée d'impulsion du générateur d'impulsions de retour.

Dans un mode de réalisation particulièrement avantageux, le générateur d'impulsions de référence comprend une source de tension de référence et une horloge.

La présente invention permet de contrôler et de stabiliser la largeur des impulsions de retour, améliorant ainsi la précision de l'opération de conversion sans introduire de bruit de quantification provenant de l'horloge qui fournit les impulsions de référence.

On décrit ci-dessous, à titre d'exemple, un convertisseur tension-fréquence de l'invention en se référant aux dessins annexés, dans lesquels:

La figure 1 est un diagramme sous forme de blocs du convertisseur; et

La figure 2 est un diagramme de circuit détaillé représentant l'un des modes de réalisation du convertisseur.

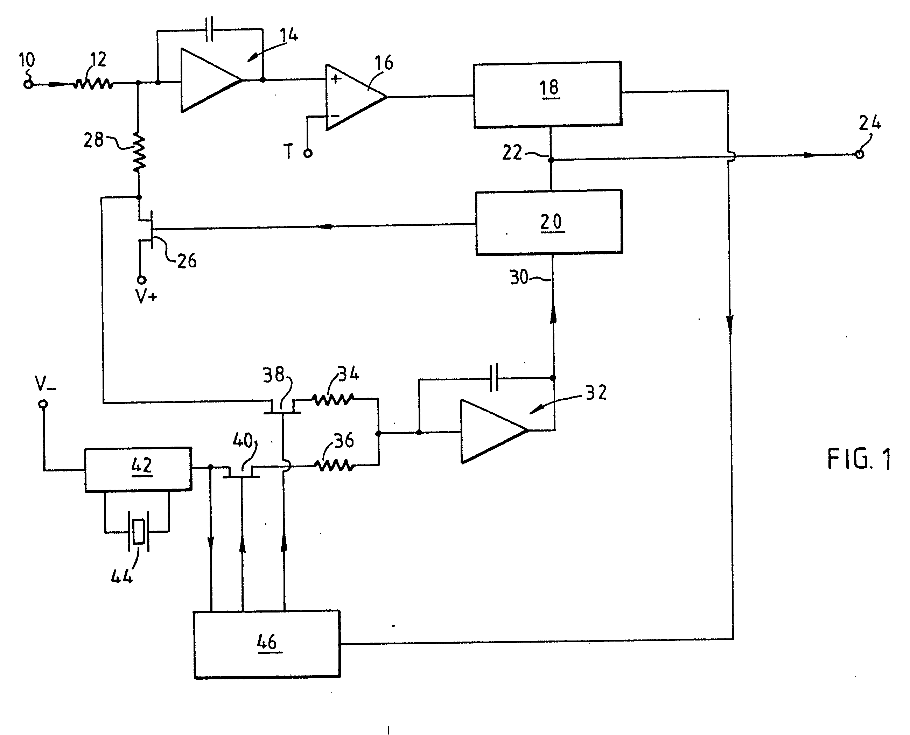

Si l'on se réfère à la fig. 1, un signal de tension d'entrée à mettre sous forme numérique, de manière que son amplitude soit représentée par la fréquence d'un autre signal, est appliqué à une borne d'entrée 10. Cette borne d'entrée est reliée par l'intermédiaire d'une résistance 12 à l'entrée d'un intégrateur 14, comprenant un amplificateur opérationnel avec rétroaction capacitive. La sortie de l'intégrateur 14 est reliée à l'une des entrées d'un comparateur 16, dont l'autre entrée reçoit une tension de seuil T. Le comparateur 16 fournit à son tour un signal de sortie à un premier circuit logique 18 qui peut déclencher un circuit monostable 20 par l'intermédiaire d'un conducteur 22. Ce conducteur 22 est également relié à une borne de sortie 24 du convertisseur. La sortie du circuit monostable 20 est reliée à la borne de commande d'un commutateur 26 (représenté dans ce cas sous forme d'un transistor MOS commandé par l'intermédiaire de sa base) qui fournit à l'entrée de l'intégrateur 14 une tension de référence positive V+ par l'intermédiaire d'une résistance 28.

Le fonctionnement du circuit décrit jusqu'ici est tout à fait classique. En conséquence, en supposant que le signal de tension d'entrée est négatif, (ou qu'un signal d'entrée bipolaire est abaissé de façon appropriée à cet effet), la tension de sortie de l'intégrateur 14 s'élève à une vitesse qui dépend de l'amplitude du signal d'entrée. Lorsque cette tension de sortie atteint la valeur de seuil T, le comparateur 16 délivre un signal au circuit logique 18 qui déclenche alors le circuit monostable 20. Ce circuit ferme ensuite le commutateur 26 pendant un temps déterminé par la durée de son état quasi-stable, provoquant ainsi l'émission d'une impulsion de retour ou contre-réaction de durée correspondante et ayant une amplitude de V+ volts appliquée à l'entrée de l'intégrateur 14. Comme cette impulsion de retour est de polarité opposée au signal d'entrée, elle a pour effet de réduire la tension de sortie de l'intégrateur 14. En outre, le circuit 18 continue à déclencher le circuit monostable 20 de façon que les impulsions de retour soient appliquées à l'intégrateur 14 en nombre suffisant pour équilibrer l'intégrale du signal d'entrée et maintenir ainsi la tension de sortie de l'intégrateur 14 à une valeur inférieure ou égale à la tension seuil T. Par conséquent, la cadence à laquelle le circuit monostable 20 est déclenché, et, donc, la fréquence de répétition des impulsions apparaissant à la borne de sortie 24, dépend de l'amplitude de la tension d'entrée appliquée à la borne d'entrée 10.

La précision de la relation liant l'amplitude du signal d'entrée à la fréquence du signal de sortie dépend en particulier de la stabilité et de la quantité de charge, ou intégrale, appliquée par chaque impulsion de retour à l'intégrateur 14. La quantité de charge est elle-même reliée à l'amplitude (définie par la tension de référence V+) et à la largeur des impulsions de retour.

Afin de stabiliser la largeur des impulsions de retour, le circuit monostable 20 comporte une seconde entrée 30 au moyen de laquelle on peut contrôler la durée de sa période quasi-stable. Cette entrée 30 est reliée à la sortie d'un second intégrateur 32 qui reçoit des signaux d'entrée, par l'intermédiaire de résistances 34 et 36, provenant de deux commutateurs 38 et 40 (également représentés sous forme de transistors MOS). Le premier de ces deux commutateurs, le commutateur 38, est connecté de façon à recevoir les mêmes impulsions de retour que celles qui sont appliquées à l'intégrateur 14 par le commutateur 26. L'autre commutateur 40 est connecté de façon à recevoir des impulsions de référence provenant d'une horloge 42 comportant une source de fréquence à cristal 44 et alimentée par une tension de référence négative V−. La valeur de cette tension de référence par rapport à la tension de référence positive V+ dépend du choix d'autres paramètres concernant l'horloge 42; sa polarité doit être telle que les impulsions de référence aient une polarité opposée à celle des impulsions de retour. Les bornes de commande des commutateurs 38 et 40 sont connectées à un second circuit logique 46 qui reçoit les signaux provenant du premier circuit logique 18 et des impulsions de référence provenant de l'horloge 42.

Chaque fois que le circuit logique 18 déclenche le circuit monostable 20, il envoie un signal correspondant au circuit logique 46. Ce circuit 46 sélectionne certaines des impulsions de retour correspondantes (par exemple chaque impulsion, ou une impulsion toutes les 10 impulsions) et les applique à l'entrée du second intégrateur 32 par fermeture du commutateur 38. Pour chacune des impulsions ainsi sélectionnées, le circuit logique 46 sélectionne et applique également une et une seule impulsion de référence au second intégrateur 32, au moyen du commutateur 40. Toute variation de la charge fournie par les deux impulsions de polarités opposées provoque une variation de la tension de sortie de l'intégrateur 32. Le circuit monostable 20 est agencé pour répondre à cette tension sur son entrée 30 en faisant varier la durée de sa période quasi-stable de façon à réduire la différence entre les charges fournies par les 2 impulsions comparées par l'intégrateur. Comme les impulsions de référence sont obtenues à partir de la tension de référence V− et de la source de fréquence à cristal 44, leur amplitude et leur largeur sont stables de sorte que la quantité de charge que chacune d'elles fournit à l'intégrateur 32 est la même. En conséquence, la largeur de l'impulsion de retour est commandée par l'intégrateur 32, de telle manière que ces impulsions fournissent également la même quantité de charge à l'intégrateur 14 et à l'intégrateur 32. Cependant, en choisissant par exemple de façon appropriée la valeur de la constante de temps de l'intégrateur 32, on peut faire en sorte que la fréquence de l'horloge 42 n'affecte pas de façon significative le libre parcours du signal impulsionnel apparaissant à la borne de circuit 24.

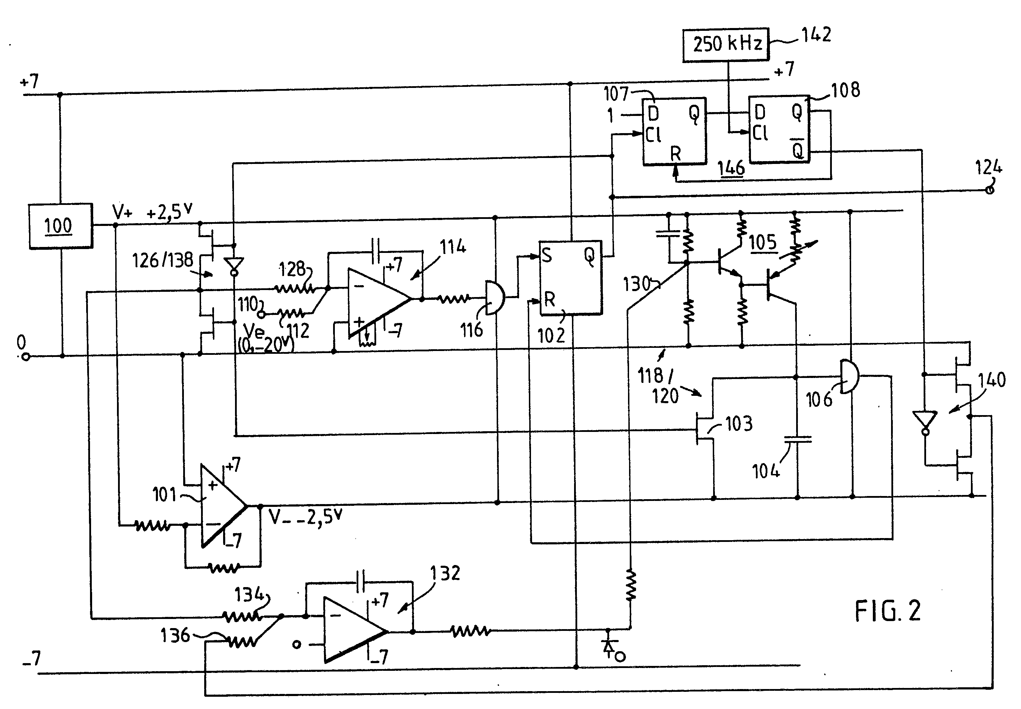

Un diagramme de circuit détaillé de l'un des modes de réalisation de convertisseur est représenté sur la fig. 2, sur laquelle les composants correspondant de manière générale aux fonctions du circuit représenté sur la fig. 1 ont été désignés par les mêmes chiffres de référence, mais augmentés de 100.

Si l'on se réfère à la fig. 2, un régulateur 100 fournit la tension de référence V+, à partir de laquelle on obtient la tension de référence V− au moyen d'un inverseur 101. Le signal de tension d'entrée est fourni par l'intermédiaire de la borne d'entrée 110 et de la résistance 112 à l'intégrateur 114, dont la tension de sortie est contrôlée par le comparateur 116. La sortie du comparateur 116 est connectée à l'entrée de validation d'une bascule RS 102 qui est en fait constituée par le circuit logique 118 et qui fait également partie du circuit monostable 120. Lorsque cette bascule 102 passe au niveau haut, sa sortie Q valide un commutateur 126/138 (dans lequel les fonctions des commutateurs 26 et 38 de la fig. 1 sont combinées) et désactive un autre commutateur 103. Le commutateur 126/138 fournit l'impulsion de retour par l'intermédiaire de la résistance 128 à l'intégrateur 114 et par l'intermédiaire de la résistance 134 à l'intégrateur 132, alors que le commutateur 103 interrompt un court-circuit du condensateur 104 du circuit monostable 120. La tension aux bornes de ce condensateur 104 commande donc à s'élever à une vitesse déterminée par le courant fourni par une source de courant réglable 105. Un comparateur 106 contrôle cette tension et, lorsqu'elle atteint le seuil de ce comparateur, ramène la bascule 102 dans son état initial, provoquant ainsi la fin de l'impulsion de retour. La borne de sortie 124 est connectée à la sortie Q de la bascule 102.

La sortie Q de la bascule 102 est également reliée à l'entrée d'horloge d'une première bascule 107 de type D dont l'entrée D est reliée au niveau logique 1. En conséquence, lorsque la bascule 102 est déclenchée, la sortie Q de la bascule 107 de type D applique un signal au niveau logique 1 à l'entrée D d'une seconde bascule de type D 108. L'entrée d'horloge de la bascule 108 reçoit les impulsions de référence provenant de l'horloge 142 et sa sortie Q est renvoyée à l'entrée de remise à l'état initial de la bascule 107 de façon que cette bascule 107 soit remise dans son état initial à l'arrivée de l'impulsion de référence suivante. Par conséquent, il n'apparaîtra qu'une et une seule impulsion de référence à la sortie inversée Q de la bascule 108 (dans ce cas particulier, l'impulsion de référence comprend un cycle complet du signal fourni par l'horloge 142).

La sortie Q inversée de la bascule 108 de type D commande le commutateur 140 qui fournit ainsi l'impulsion de référence à l'intégrateur 132 par l'intermédiaire de la résistance 136. La sortie de l'intégrateur 132 est reliée à la source de courant 105 de façon à commander sa conductivité et à faire varier la vitesse à laquelle le condensateur 104 se charge, faisant ainsi varier la durée de l'état quasi-stable du circuit monostable 120.

**Revendications**

1. Convertisseur tension-fréquence conçu pour fournir un signal de sortie oscillant (en 24) dont la fréquence est représentative de l'amplitude d'un signal d'entrée, comprenant:
– un intégrateur (14) destiné à intégrer le signal d'entrée et des impulsions de retour fournies à l'intégrateur à une fréquence et avec une polarité telles que le signal de sortie de l'intégrateur est astreint à conserver une valeur au plus égale à une valeur de seuil prédéterminée, et
– un générateur d'impulsions de retour (20–26) fonctionnellement relié à la sortie de l'intégrateur et commandé pour fournir à l'intégrateur une impulsion de retour chaque fois que le signal de sortie de cet intégrateur atteint ladite valeur de seuil, caractérisé en ce qu'il comprend en outre d'une part un générateur d'impulsions de référence (42, 40) délivrant, à une fréquence dépendant de celle des impulsions de retour, des impulsions de référence calibrées, et d'autre part un second intégrateur (32) intégrant, avec des polarités opposées, les impulsions de retour et de référence, le signal de sortie de ce second intégrateur étant appliqué à une entrée de contrôle (30) de durée d'impulsion du générateur d'impulsions de retour.

2. Convertisseur tension-fréquence suivant la revendication 1, caractérisé en ce que le générateur d'impulsions de référence comprend une source de tension de référence (V–) et une horloge (42).

**Claims**

1. A voltage-frequency converter designed to provide an output oscillating signal (at 24) the frequency of which is representative of the amplitude of an input signal, which comprises:
– an integrator (14) for integrating the input signal and return pulses fed to the integrator with such frequency and polarity that the output signal from the integrator is forced to maintain a value at most equal to a predetermined threshold value, and
– a return pulse generator (20–26) functionnally coupled to the output of the integrator and controlled for providing the integrator with a return pulse each time the output signal from said integrator reaches said threshold value, characterized in that it further comprises, on the one hand, a reference pulse generator (42, 40) which delivers, at a frequency depending on that of the return pulses, calibrated references pulses, and on the other hand, a second integrator (32) which integrates, with opposite polarities, the return and reference pulses, wherein the output signal from this second integrator is applied to a pulse duration control input (30) of the return pulse generator.

2. A voltage-frequency converter according to claim 1, wherein the reference pulse generator comprises a reference voltage source (V–) and a clock (42).

**Patentansprüche**

1. Spannungs/Frequenz-Umsetzer, der zur Lieferung eines Schwingungs-Ausgangssignals (bei 24) ausgelegt ist, dessen Frequenz für die Amplitude eines Eingangssignals repräsentativ ist, enthaltend:
– einen Integrator (14) zum Integrieren des Eingangssignals und der Rückstatimpulse, die dem Integrator mit solcher Frequenz und Polarität zugeführt werden, dass das Ausgangssignal des Integrators gezwungen ist, einen Wert zu behalten, der höchstens gleich einem vorbestimmten Schwellwert ist, und
– einen Rücktastimpulsgenerator (20–26), welcher funktionsmässig mit dem Ausgang des Integrators verbunden und so gesteuert ist, dass er dem Integrator einen Rücktastimpuls jedesmal dann zuführt, wenn das Ausgangssignal dieses Integrators den genannten Schwellwert erreicht, dadurch gekennzeichnet, dass er ferner einerseits einen Referenzimpulsgenerator (42, 40) enthält, der geeichte Referenzimpulse mit einer Frequenz abgibt, welche von der der Rücktastimpulse abhängt, und andererseits einen zweiten Integrator (32) enthält, der die Rücktast- und Referenzimpulse mit entgegengesetzten Polaritäten integriert, wobei das Ausgangssignal dieses zweiten Integrators an einen Steuereingang (30) zur Steuerung der Impulsdauer am Rücktastimpulsgenerator angelegt ist.

2. Spannungs/Frequenz-Umsetzer nach Anspruch 1, dadurch gekennzeichnet, dass der Referenzimpulsgenerator eine Referenzspannungsquelle (V–) und eine Zeitbasis (42) enthält.

FIG. 1

0 086 140

FIG. 2